# EUROPEAN PATENT APPLICATION

(11) **EP 2 869 337 A2**
(43) Date of publication of application: **06.05.2015**
(21) Application number: 14189378.4
(22) Date of filing: 17.10.2014
(51) Int. Cl.: H01L 23/367

(54) **Electrical assembly with a solder sphere attached heat spreader**

(30) Priority: 29.10.2013 US 201314065856
(71) Applicant: Delphi Technologies, Inc., Troy MI 48007 (US)
(72) Inventor: Vadas, Robert L., Noblesville, IN Indiana 46060 (US); Gilbertson, Kurt E., Peru, IN Indiana 46970 (US)
(74) Representative: Robert, Vincent

(57) **Abstract**

An electrical assembly (10) that includes a circuit board (12), an electrical device (14), a heat spreader (26), and a solder sphere (36). The electrical device (14) is a surface mount type package attached to the circuit board (12). The heat spreader (26) overlies and extends beyond the outline (28) of the device (14), and is in thermal contact the top side of the surface mount type package. A contact surface (30) of the heat spreader (26) is spaced apart from a mounting surface (18) of the circuit board (12) by a distance (32) based on a height (34) of the top side above the mounting surface (18). The solder sphere (36) has a pre-reflow diameter sufficient to couple the contact surface (30) to the mounting surface (18) after the solder sphere (36) is reflowed.

## Description

### TECHNICAL FIELD

This disclosure generally relates to an electrical assembly with a heat spreader, and more particularly relates to using a large solder sphere that is reflowed to couple the heat spreader to a circuit board or substrate.

### BACKGROUND OF INVENTION

It is known to attach or thermally couple a heat sink or heat spreader to a packaged electrical device (e.g. - a packaged integrated circuit) to help dissipate heat generated by the electrical device. For relatively high power instances, greater than two Watts (2W) for example, a housing or enclosure may be configured to make contact with the top side of an electrical device to provide a thermal path for dissipating heat generated by the electrical device. However, it has been learned that it can be difficult and/or expensive to design and manufacturer such an arrangement that also avoids imparting undesirable stress onto the electrical device, especially when exposed to wide variations in temperature that can cause stress by way of mismatched coefficients of thermal expansion (CTE).

### SUMMARY OF THE INVENTION

In accordance with one embodiment, an electrical assembly is provided. The electrical assembly includes a circuit board, an electrical device, a heat spreader, and a solder sphere. The electrical device is attached to the circuit board. The electrical device is packaged in a surface mount type package. A bottom side of the surface mount type package is oriented toward a mounting surface of the circuit board. The surface mount type package couples heat from the device to a top side of the surface mount type package that is opposite the bottom side. The heat spreader overlies the electrical device. The heat spreader is configured to extend beyond an outline of the device. A contact surface of the heat spreader is in thermal contact with the top side, and the contact surface is spaced apart from the mounting surface by a distance based on a height of the top side above the mounting surface. The solder sphere has a pre-reflow diameter sufficient to couple the contact surface to the mounting surface after the solder sphere is reflowed.

Further features and advantages will appear more clearly on a reading of the following detailed description of the preferred embodiment, which is given by way of non-limiting example only and with reference to the accompanying drawings.

### BRIEF DESCRIPTION OF DRAWINGS

The present invention will now be described, by way of example with reference to the accompanying drawings, in which:
Fig. 1 is a side view of an electrical assembly in accordance with one embodiment;
Fig. 2 is a side view of an alternative electrical assembly in accordance with one embodiment; and
Fig. 3 is a side view of an alternative electrical assembly in accordance with one embodiment.

### DESCRIPTION OF THE PREFERRED EMBODIMENT

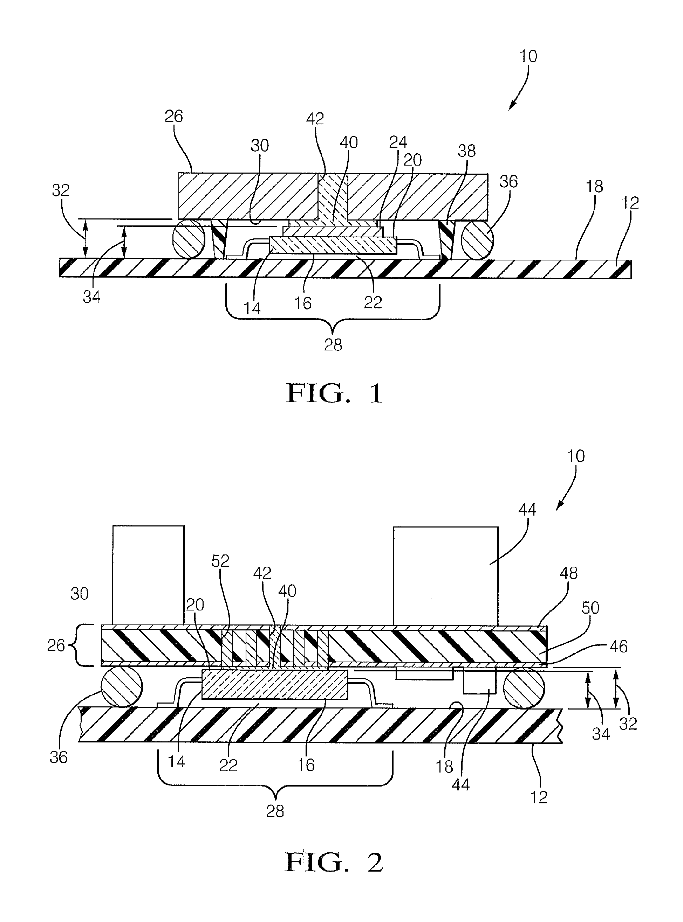

Fig. 1 illustrates a non-limiting example of an electrical assembly 10, hereafter referred to as the assembly 10. While not shown, it is contemplated that the assembly 10 may include a housing or enclosure to protect the various parts of the assembly 10 described herein from damage by physical impact, moisture, chemical contamination, and the like. As will be described in more detail below, the assembly 10 provides a low cost way to provide heat dissipation for a surface mount type packaged device that generally imparts lower stress/strain on the packaged device as compared to heat dissipation schemes that thermally couple the top side of a surface mount type packaged device to a housing or enclosure. Furthermore, the assembly 10 described herein may also provide a Faraday shield around the device intended to improve electromagnetic interference (EMI) performance.

The assembly 10 generally includes a circuit board 12. The circuit board 12 may be formed of any of several known materials including ceramic materials such as alumina (Al2O3) with solderable contacts formed of metallized thick-film ink or deposited thin-film, or glass-epoxy materials such as FR-4 with solderable contacts formed of copper foil. The selection of materials to form the circuit board 12 may be, for example, based on the intended operating environment of the assembly, and/or based on a preferred selection due to limitations of certain components that will be attached to the circuit board 12, as will be recognized by those in the art.

The assembly 10 generally includes an electrical device 14 attached to the circuit board 12, and hereafter referred to as the device 14. As used herein, the device 14 is a semi-conductor component such as an integrated circuit or transistor packaged in a surface mount type package that is encapsulated in epoxy, thermal-set compound, or any of the other known materials used for encapsulating packaged components that are commonly referred to as plastic encapsulated components. Known comparable packaging configurations include, but are not limited to, gull-wing type leaded packages such as small outline (SO) and quad-flat-pack (QFP), J-lead (lead bent under package body in a 'J' shape) such as plastic-leaded chip carrier (PLCC), and leadless packages such leadless chip carrier (LCC) and ball grid array (BGA).

In general, the device 14 (i.e. - the package of the device 14) defines a bottom side 16 that is oriented toward a mounting surface 18 of the circuit board 12, and a top side 20 opposite the bottom side 16. In general, the leads or solder balls used to attach the package of the device 14 to the circuit board may cause an air gap 22 between the bottom side 16 and the mounting surface 18. Those in the art will recognize that the air gap 22 typically reduces thermal coupling between the device 14 and the circuit board 12. As such, heat from the device may not be as efficiently dissipated as possible. In particular, the package couples heat from the device 14 to the top side 20 of the package, and so an opportunity to improve heat dissipation is presented. Furthermore, the top side 20 of the package may optionally include a thermal conductor 24 configured to couple heat from the device 14 within the package to the top side 24. The thermal conductor 24 is illustrated here as protruding from the body of the package only to simplify the illustration. It is contemplated that the thermal conductor 24 may be integrated into the package in such a way as to make the thermal conductor 24 appear to be even with or flush with the top side 20. That is, the thermal conductor 24 may cooperate with the package to define the top side 20.

In order to improve heat dissipation, the assembly 10 may include a heat spreader 26 overlying and in thermal contact with the device 14. For reasons that will become apparent, the heat spreader 26 is preferable configured to extend beyond an outline 28 of the device. In general, the heat spreader 26 defines a contact surface 30 of the heat spreader 26 that is in thermal contact with the top side 20. In general, the contact surface 30 is spaced apart from the mounting surface 18 by a distance 32 based on a height 34 of the top side 20 above the mounting surface 18. It is noted that the distance 32 may be greater than the height 34 if, for example, the assembly 10 includes the assembly includes thermally conductive material, e.g. thermal grease, between the heat spreader 26 and the device 14.

The heat spreader 26 is preferable formed of a thermally conductive material to facilitate dissipating heat from the device 14. For reasons that will become apparent, the heat spreader 26 is also preferably made of a material that has a coefficient of thermal expansion (CTE) similar to the CTE of the circuit board 12. For example, if the circuit board 12 is formed of a ceramic material, the heat spreader 26 may be formed of the same ceramic material, or a thermally conductive material with a similar CTE such as the alloy KOVAR®. If the circuit board 12 is what is commonly called a printed circuit board formed of layers of copper foil and FR-4 epoxy/glass laminate, then the heat spreader 26 may also be formed of similar materials with, for example, a particularly thick layer of copper foil to facilitate spreading heat.

By configuring the heat spreader 26 to extend beyond the outline 28 of the device 14, the assembly 10 may include a solder sphere 36 having a pre-reflow diameter sufficient to couple with or adhere to the contact surface to the mounting surface after the solder sphere is reflowed. After the solder sphere 36 is placed as shown, the assembly 10 is subjected to an appropriate temperature profile to reflow the solder sphere 36. It should be recognized that the mounting surface 18 and the contact surface 30 would be suitable prepared so the solder sphere 36 would wet to the mounting surface 18 and the contact surface 30 during reflow. The solder sphere 36 is shown has having a spherical shape as would be expected prior to reflow. However, it is understood that after reflow the solder sphere 36 would not have a spherical shape, but would show evidence of wetting to the mounting surface 18 and the contact surface 30, possibly taking on an hour-glass shape.

As used herein, the term solder sphere is used to indicate a size or quantity of solder that is larger or greater than what is normal for solder balls used with ball-grid-array (BGA) type packaging. Solder balls for BGA packaging normally have a pre-reflow diameter (i.e. the diameter prior to reflow) of less than one millimeter (1.0mm), while the solder sphere 36 described herein would have a pre-reflow diameter greater than one millimeter (1.0mm).

It has been observed that if the heat spreader 26 is relatively light weight and/or a sufficient number of solder spheres are present between the heat spreader 26 and the circuit board 12, the distance 32 can be well controlled, within +/- 0.1 mm for example. However, if the weight of the heat spreader 26 is too great for the solder spheres to support during reflow, excessive collapse of the solder spheres may occur. To avoid this problem, the assembly 10 may include one or more stand-offs 38 interposed between the contact side 30 and the mounting surface 18 to prevent excessive collapse of the solder sphere 36 during reflow. The stand-offs 38 may be comparable in the shape to pillars or posts so that three of the stand-offs 38 could be used to support the heat spreader 26 at whatever value is desired for the distance 32. Alternatively, the standoffs 38 may be comparable in the shape to walls so that two wall sections could be used to support the heat spreader 26. The stand-offs 38 may be separate parts so the heat spreader 26 could be a simple and inexpensive flat shaped part. Alternatively, the stand-offs 38 may be integrally formed as part of the heat spreader 26.

As suggested above, the assembly 10 may include thermally conductive material 40 between the heat spreader 26 and the device 14. The thermally conductive material 40 may be the well-known thermal grease that is often applied between electrical components and heat sinks. Alternatively, the thermally conductive material 40 may be a metal particle or ceramic particle infused adhesive that is applied while in liquid or paste form, and then cured in place. To allow for the application of the thermally conductive material 40 after the heat spreader 26 is secured to the circuit board 12 by the solder sphere 36, the heat spreader 26 may include or define a hole 42 proximate to the device 14, in particular the thermal conductor 24. As such, the assembly 10 may include thermally conductive material 40 between the heat spreader 26 and device 14 that was injected into the hole 42.

Fig. 2 shows a non-limiting example of an embodiment of the assembly 10 where the heat spreader 26 is a multi-layer printed circuit board. Such a configuration may be advantageous as the heat spreader 26 can also be used to support various electrical components 44 above the heat spreader 26 and/or between the heat spreader 26 and the circuit board 12. For this example, the heat spreader 26 includes a first metal layer 46 thermally coupled to the device 14 and attached to a first side of a substrate layer 50 configured to support the first metal layer 46. The heat spreader 26 may also include a second metal layer 48 attached to a second side of the substrate layer 50 opposite the first side. The heat spreader 26 may also include a via 52 configured to thermally couple the first metal layer 46 to the second metal layer 48. Materials and fabrication techniques of a multi-layer printed circuit board suitable for use as the heat spreader 26 are well-known and readily available. It is further noted that the solder sphere 36 can provide an electrical connection between the heat spreader 26 and the circuit board 12 and thereby form a Faraday cage to help protect the device 14 from electromagnetic interference.

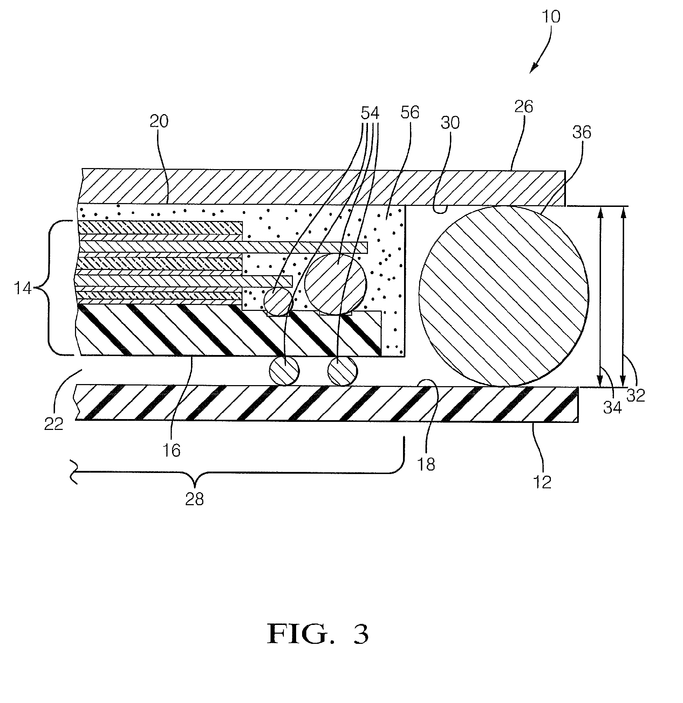

Fig. 3 illustrates a non-limiting example of the assembly where the device 14 is a multi-chip ball-grid-array (BGA) type package that uses solder balls 54 for interconnections within the encapsulant 56 that defines the exterior of the device 14, and solder balls 54 to attach the device 14 to the circuit board. While no thermally conductive material 40 is specifically shown, and so the distance 32 is illustrated as equal to the height 34, it is contemplated that thermally conductive material 40 could be applied if desired. Furthermore, other features shown in Figs. 1 and 2 such as the stand-offs 38 and electrical components 44 are not shown only to simplify the illustration, and their absence is not a suggestion that they are excluded from use in this example. It is noted that the solder sphere 36 is sized to span the distance 32, and so is substantially larger than the solder balls 54.

Accordingly, an electrical assembly (the assembly 10) with a solder sphere attached heat spreader is provided. The assembly 10 provides an economical way to dissipate heat from a device 14 that does not dissipate so much power that thermal coupling to a housing or similar large structure is required. Furthermore, suitable materials can be selected so the coefficient of thermal expansion (CTE) characteristics of the various parts that make up the assembly 10 are such that stress and strain on, for example, solder joints that attach the device to the circuit board 12 can be minimized.

While this invention has been described in terms of the preferred embodiments thereof, it is not intended to be so limited, but rather only to the extent set forth in the claims that follow.

## Claims

1. An electrical assembly (10) comprising:
a circuit board (12);
an electrical device (14) attached to the circuit board (12), wherein the device (14) is packaged in a surface mount type package, wherein a bottom side of the package is oriented toward a mounting surface (18) of the circuit board (12), wherein the package couples heat from the device (14) to a top side of the package opposite the bottom side;
a heat spreader (26) overlying the electrical device (14) and configured to extend beyond an outline (28) of the device (14), wherein a contact surface (30) of the heat spreader (26) is in thermal contact with the top side, and the contact surface (30) is spaced apart from the mounting surface (18) by a distance (32) based on a height (34) of the top side above the mounting surface (18); and
a solder sphere (36) having a pre-reflow diameter sufficient to couple the contact surface (30) to the mounting surface (18) after the solder sphere (36) is reflowed.

2. The assembly (10) in accordance with claim 1, wherein the pre-reflow diameter is greater than one millimeter (1.0mm).

3. The assembly (10) in accordance with claim 1 or 2, wherein the assembly (10) includes stand-offs (38) interposed between the contact side and the mounting surface (18) to prevent excessive collapse of the solder sphere (36) during reflow.

4. The assembly (10) in accordance with any one of claims 1 to 3, wherein the heat spreader (26) defines a hole (42) proximate to the device (14).

5. The assembly (10) in accordance with claim 4, wherein the assembly (10) includes thermally conductive material (40) between the heat spreader (26) and device (14) that was injected into the hole (42).

6. The assembly (10) in accordance with any one of claims 1 to 5, wherein the heat spreader (26) includes a first metal layer (46) thermally coupled to the device (14), wherein the first metal layer (46) is attached to a first side of a substrate layer (50) configured to support the first metal layer (46).

7. The assembly (10) in accordance with claim 6, wherein the heat spreader (26) includes a second metal layer (48) attached to a second side of the substrate layer (50) opposite the first side, and a via configured to thermally couple the first metal layer (46) to the second metal layer (48).

8. The assembly (10) in accordance with claim 7, wherein the assembly (10) includes an electrical component attached to the first metal layer (46).

9. The assembly (10) in accordance with claim 7 or 8, wherein the assembly (10) includes an electrical component attached to the second metal layer (48).

10. The assembly (10) in accordance with any one of claims 1 to 9, wherein the top side of the package includes a thermal conductor (24) configured to couple heat from the device (14) to the top side.
